# EUROPÄISCHE PATENTSCHRIFT

(11) **EP 3 236 489 B1**
(45) Veröffentlichungstag und Bekanntmachung des Hinweises auf die Patenterteilung: **03.09.2025**
(21) Anmeldenummer: 17151929.1
(22) Anmeldetag: 25.11.2014
(51) Int. Cl.: H01L 21/48, H01L 23/538, H01L 21/60, H01L 23/495, H01L 23/498

(54) **VERFAHREN ZUR HERSTELLUNG EINES CHIPMODULS**
METHOD FOR PRODUCING A CHIP MODULE
PROCÉDÉ DE FABRICATION D'UN MODULE DE PUCE

(30) Priorität: 27.12.2013 DE 102013114907
(43) Veröffentlichungstag der Anmeldung: 25.10.2017
(62) Teilanmeldung aus: 14815258.0
(73) Patentinhaber: Pac Tech - Packaging Technologies GmbH, 14641 Nauen (DE)
(72) Erfinder: AZDASHT, Ghassem, 13591 Berlin (DE); TEUTSCH, Thorsten, Santa Cruz, CA 95060 (US); GEELHAAR, Ricardo, 13591 Berlin (DE)
(74) Vertreter: advotec.

(56) Entgegenhaltungen:
- EP-A2- 1 848 030
- US-A1- 2009 194 882
- US-A1- 2009 261 468
- US-A1- 2010 148 381
- US-A1- 2011 291 252
- US-A1- 2012 273 960

## Beschreibung

Die vorliegende Erfindung betrifft ein Verfahren zur Herstellung eines Chipmoduls mit einem Trägersubstrat und zumindest einem auf dem Trägersubstrat angeordneten Chip sowie einer Kontaktleiteranordnung zur Verbindung von Chipanschlussflächen mit auf einer Kontaktseite des Chipmoduls angeordneten Anschlusskontakten, bei dem der Chip mit seiner mit den Chipanschlussflächen versehenen Frontseite auf dem Trägersubstrat fixiert wird und nachfolgend die Ausbildung der Kontaktleiteranordnung durch eine Strukturierung einer Kontaktmateriallage des Trägersubstrats erfolgt.

Chipmodule, die häufig fachterminologisch auch als "chip package" bezeichnet werden, weisen grundsätzlich ein mit einer Kontaktleiteranordnung versehenes Trägersubstrat und einen in einer Chipgehäusung geschützt aufgenommenen Chip auf, der über seine Chipanschlussflächen mit der Kontaktleiteranordnung kontaktiert ist. Die Kontaktleiteranordnung hat dabei im Wesentlichen die Aufgabe, eine für die äußere Kontaktierung des Chipmoduls geeignete Anordnung von Anschlusskontakten auszubilden, wobei die Anschlusskontakte einen größeren Abstand voneinander aufweisen als die Chipanschlussflächen sowie größere Kontaktflächen aufweisen, um die äußere Kontaktierung des Chipmoduls zu vereinfachen. Ein Chipmodul mit einem vergossenen Halbleiterchip, bei dem eine äußere Kontaktierung zweier gegenüberliegender Chipoberflächen ermöglicht ist, wird in der US 2009/0261468 A1 vorgeschlagen. Auch in der US 2009/0194882 A1 und der US 2012/0273960 und der US 2011/291252 sind Halbleitermodule umfassend Chips mit Kontaktflächen auf einer Front- und einer Rückseite beschrieben.

Insbesondere kann mittels der Kontaktleiteranordnung eine Anpassung an Anschlusskontaktanordnungen von weiteren Chipmodulen oder Platinen vorgenommen werden, so dass das Chipmodul ohne weiteren Umverdrahtungsaufwand mit dem weiteren Chipmodul oder der Platine kontaktiert werden kann. Die Kontaktleiteranordnung kann daher auch als integrierte "Umverdrahtung" des Chipmoduls aufgefasst werden, die eine externe Umverdrahtung zwischen miteinander zu kontaktierenden Chipmodulen überflüssig macht. Das besondere Layout bzw. die besondere, das Chipmodul individualisierende Verteilung der äußeren Anschlusskontakte wird auch häufig als sogenannter "footprint" bezeichnet.

Bekannte Verfahren zur Herstellung eines Chipmoduls sehen beispielsweise vor, dass als Chipträger ein Substrat aus einem dielektrischen Material verwendet wird, das mit einer Kontaktleiteranordnung zur Ausbildung der "internen Umverdrahtung" versehen wird, wobei nach Herstellung der Kontaktleiteranordnung die Kontaktierung des Chips auf dem Chipträger und anschließend die Ausbildung einer den Chip aufnehmenden Chipgehäusung auf dem Chipträger dadurch erfolgt, dass der Chip von einem sogenannten "mold" umhüllt wird, der in flüssigem Zustand auf den Chip aufgebracht wird und nach Aushärtung die beabsichtigte schützende Gehäusung für den Chip ausbildet.

Der vorliegenden Erfindung liegt die Aufgabe zugrunde, ein Verfahren vorzuschlagen, das die Herstellung eines Chipmoduls wesentlich vereinfacht und insbesondere eine industrielle Herstellung von Chipmodulen mit hohen Stückzahlen mit einem geringen Kostenaufwand ermöglicht.

Zur Lösung dieser Aufgabe weist das erfinderische Verfahren die Merkmale des unabhängigen Anspruchs 1 auf. Weitere Ausführungsformen sind durch die abhängigen Ansprüche 2-10 definiert. Bei dem erfindungsgemäßen Verfahren wird der Chip mit seiner mit Chipanschlussflächen versehenen Frontseite auf einer Kontaktmateriallage eines Trägersubstrats fixiert. Nach erfolgter Fixierung zur Positionierung des Chips auf dem Trägersubstrat, erfolgt die Ausbildung der Kontaktleiteranordnung durch eine Strukturierung des Kontaktmaterials des Trägersubstrats. Hiermit erübrigt sich die Bereitstellung von Chipträgern, die bereits mit einer Kontaktleiteranordnung versehen sind. Vielmehr kann die Ausbildung der Kontaktleiteranordnung mit einem das Chipmodul individualisierenden foot-print zusammen mit der Herstellung des Chipmoduls erfolgen.

Im Unterschied zu dem eingangs erörterten bekannten Verfahren erfolgt also bei dem erfindungsgemäßen Verfahren zur Herstellung eines Chipmoduls zum einen die Anordnung des Chips auf dem Trägersubstrat vor der Ausbildung der Kontaktleiteranordnung. Zum anderen erfolgt die Ausbildung der Kontaktleiteranordnung dadurch, dass das aus dem Kontaktmaterial gebildete Trägersubstrat strukturiert wird.

Vorteilhafte Ausführungsformen der Erfindung sind Gegenstand der abhängigen Ansprüche.

Vorzugsweise erfolgt die Fixierung des Chips auf dem Trägersubstrat dadurch, dass der Chip mit seiner mit Chipanschlussflächen versehenen Frontseite auf einer adhäsiven Beschichtung der Kontaktmateriallage des Trägersubstrats angeordnet wird. Aufgrund der adhäsiven Beschichtung des Trägersubstrats kann beispielsweise darauf verzichtet werden, die Position des Chips auf dem Trägersubstrat definierende Ausnehmungen im Trägersubstrat oder dergleichen vorzusehen. Damit kann das Trägersubstrat besonders einfach mit ebenen Oberflächen ausgestaltet sein.

Besonders vorteilhaft ist es, wenn das Trägersubstrat aus einer Kontaktmaterialfolie gebildet ist, die eine besonders dünne Ausgestaltung des aus dem Kontaktmaterial gebildeten Trägersubstrats ermöglicht. Darüber hinaus kann die Kontaktmaterialfolie zur Ausbildung des Trägersubstrats als Endlosmaterial zur Verfügung gestellt werden, wodurch eine automatisierte Inline-Herstellung des Chipmoduls in großer Stückzahl erleichtert wird, da die Kontaktmaterialfolie gleichzeitig als Endlosförderer für eine getaktete Vorbewegung im Herstellungsprozess des Chipmoduls verwendet werden kann.

Besonders vorteilhaft ist es, wenn für das Trägersubstrat eine Kontaktmaterialfolie verwendet wird, die bereits mit einer adhäsiven Beschichtung versehen ist, so dass ein Auftrag einer adhäsiven Beschichtung in einem separaten Verfahrensschritt vorausgehend der Bestückung des Trägersubstrats mit dem Chip nicht notwendig ist.

Beispielsweise können die Verbindungskontakte dadurch ausgebildet werden, dass als Kontaktmaterial ein Lotmaterial verwendet wird, das in die Kontaktausnehmungen appliziert wird. Eine derartige Applikation von Lotmaterial kann beispielsweise mittels eines Verfahrens erfolgen, bei dem aufgeschmolzene Lotmaterialdepots auf die mittels der Kontaktausnehmungen zugänglichen Chipanschlussflächen geschleudert werden.

Eine weitere Möglichkeit, Kontaktmaterial in die Kontaktausnehmungen einzubringen, liegt darin, das Kontaktmaterial durch ein Abscheideverfahren in die Kontaktausnehmungen einzubringen, wobei grundsätzlich sowohl ein galvanisches Abscheideverfahren als auch ein stromloses Abscheideverfahren infrage kommt, bei dem das Kontaktmaterial vorzugsweise durch autokatalytische Abscheidung, also beispielsweise durch Abscheidung von Nickel und/oder Gold, erfolgt. Zur Verbesserung der Haftung zwischen den autokatalytischen abgeschiedenen Metallen und den Chipanschlussflächen kann dabei vorteilhaft eine elektrolytische Beaufschlagung der Anschlussflächen mit Zinkat oder auch Palladium erfolgen, um eine "Bekeimung" der Chipanschlussflächen vorzunehmen.

Es ist auch denkbar, dass alternativ zu der Kontaktierung der Chipanschlussflächen mit dem Trägersubstrat durch Ausbildung von Kontaktausnehmungen in der Kontaktmateriallage durch Strukturierung der Kontaktmateriallage und Verfüllung der Kontaktausnehmungen mit Kontaktmaterial vor Ausbildung der Kontaktleiteranordnung eine Kontaktierung der Chipanschlussflächen mit der Kontaktmateriallage auch unabhängig von der Strukturierung der Kontaktmateriallage erfolgen kann.

Vorzugsweise werden zur Kontaktierung der Chipanschlussflächen mit der Kontaktmateriallage die mit Kontakterhöhungen versehenen Chipanschlussflächen zur Anlage gegen die Kontaktmateriallage gebracht, und nachfolgend erfolgt die Verbindung der Chipanschlussflächen mit der Kontaktmateriallage durch Aufschmelzen der Kontakterhöhungen. Dabei kann die Fixierung des Chips auf dem Trägersubstrat auch gleichzeitig mit Ausbildung des Verbindungskontakts zur Kontaktmateriallage erfolgen.

Besonders vorteilhaft ist es, wenn das Aufschmelzen der Kontakterhöhungen mittels einer Laserbeaufschlagung des Chips oder der Kontaktmateriallage erfolgt.

Insbesondere dann, wenn das Hüllmaterial als Hüllmateriallage auf den Chip aufgelegt wird, derart, dass der Chip sandwichartig zwischen der Hüllmateriallage und dem Trägersubstrat angeordnet ist, und die Hüllmateriallage nachfolgend in einem Laminiervorgang zur Ausbildung einer das Trägersubstrat umfassenden Laminatstruktur mit dem Trägersubstrat verbunden wird, bildet die Hüllmateriallage eine das Trägersubstrat aussteifende Stützeinrichtung, so dass selbst in dem Fall der Ausbildung des Trägersubstrats als Folienmaterial eine Bearbeitung des Trägersubstrats zur Strukturierung der Kontaktmateriallage erfolgen kann, ohne dass die Flexibilität des Trägersubstrats die Bearbeitung erschweren würde.

Zur Kontaktierung der Chiprückseite ist es besonders vorteilhaft, wenn die Chiprückseite zunächst durch Beaufschlagung des Hüllmaterials mit Laserstrahlung freigelegt wird und nachfolgend eine Abscheidung eines Kontaktmaterials auf die Chiprückseite zur Herstellung eines Kontakts zwischen der Chiprückseite und der Chiprückseitenkontaktlage erfolgt.

Nachfolgend werden Bezug nehmend auf die Zeichnung verschiedene Varianten der Herstellung eines Chipmoduls erläutert.

Es zeigen:
Fig. 1 bis 13
   die Herstellung eines Chipmoduls gemäß einer ersten Ausführungsform des Verfahrens in aufeinanderfolgenden Verfahrensschritten, die unter die beigefügten Ansprüche fällt;
Fig. 14 bis 21
   die Herstellung eines Chipmoduls gemäß einer Variante des Verfahrens in verschieden aufeinanderfolgenden Verfahrensschritten, wobei die Variante nicht unter die beigefügten Ansprüche fällt;
Fig. 22 und 23
   die Ausbildung eines Verbindungskontakts zwischen Chips und einem Trägersubstrat über Kontakterhöhungen, die unter die beigefügten Ansprüche fällt;
Fig. 24 die Laminatstruktur eines Chipmoduls vor Strukturierung der Kontaktmateriallage;
Fig. 25 die Strukturierung der Kontaktmateriallage zur Ausbildung des Chipmoduls;
Fig. 26 die Laminatstruktur eines Chipmoduls vor Strukturierung der Kontaktmateriallage, wobei diese nicht unter die beigefügten Ansprüche fällt;
Fig. 27 die Strukturierung der Kontaktmateriallage zur Ausbildung des Chipmoduls, wobei diese nicht unter die beigefügten Ansprüche fällt.

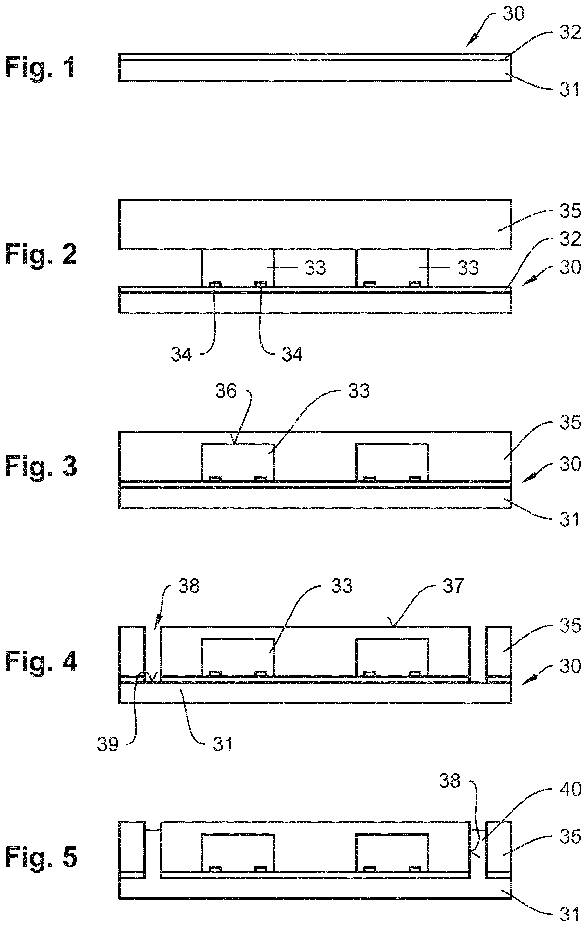

Fig. 1 zeigt als Ausgangsbasis zur Ausführung des Verfahrens die Bereitstellung eines Trägersubstrats 30 mit einer aus einem Kontaktmaterial 31 gebildeten metallischen Folie, die im vorliegenden Fall als KupferFolie ausgebildet ist. Das Trägersubstrat 30 ist mit einer adhäsiven Beschichtung 32 versehen, die beispielsweise als ein thermisch aktivierbares Epoxydharz ausgebildet sein kann. Vorstellbar ist jedoch auch, dass die Beschichtung als eine auch unabhängig von einer Aktivierung adhäsive Schicht ausgebildet ist, die zur Handhabung oder Bereitstellung der Trägerfolie mit einem Peel-off-Papier oder Ähnlichem versehen sein kann, so dass die Trägerfolie beispielsweise auch in Rollenform, also aufgerollt, bereitgehalten werden kann.

Wie Fig. 2 zeigt, erfolgt zu Beginn des Verfahrens eine Anordnung von zumindest einem Chip, im vorliegenden Fall mehreren Chips 33, die mit ihren nach unten gerichteten Chipanschlussflächen 34 auf dem Trägersubstrat 30 angeordnet werden, wobei durch die adhäsive Beschichtung 32 eine die Chips 33 auf dem Trägersubstrat 30 positionierende Fixierung erfolgt.

Anschließend wird eine vorzugsweise aus einer im Wesentlichen ein Epoxydharz aufweisenden Materialmischung bestehende Hüllmateriallage 35 auf den Chips 33 so angeordnet, dass die Chips 33 nunmehr sandwichartig zwischen dem Trägersubstrat 30 und der Hüllmateriallage 35 aufgenommen sind. Im nun folgenden Laminierschritt wird die Hüllmateriallage 35 unter gleichzeitiger Einwirkung von Druck und Temperatur zur Anlage gegen das Trägersubstrat 30 gebracht, wobei das Material der Hüllmateriallage 35 durch die Chips 33 verdrängt wird, mit der Folge, dass, wie in Fig. 3 dargestellt, nach Abschluss des Laminierschrittes die Chips 33 eingebettet in der Hüllmateriallage 35 aufgenommen sind, derart, dass insbesondere Chiprückseiten 36 der Chips 33 durch das Material der Hüllmateriallage 35 abgedeckt sind. Das Material der Hüllmateriallage 35 ist in seiner Zusammensetzung so gewählt, dass der thermische Ausdehnungskoeffizient des Hüllmaterials möglichst dem thermischen Ausdehnungskoeffizienten des Kontaktmaterials 31 des Trägersubstrats 30 angenähert ist. Beispielsweise kann dies dadurch erreicht werden, dass der Epoxyd-Basis des Hüllmaterials als Füller ein Siliziumoxyd in ausreichendem Maß beigemengt wird, wodurch beispielsweise ein thermischer Ausdehnungskoeffizient im Bereich von 7 bis 8 K-1 erreichbar ist, der vom thermischen Ausdehnungskoeffizienten von Kupfer, das bevorzugt ein wesentlicher Bestandteil des Kontaktmaterials 31 ist und das einen thermischen Ausdehnungskoeffizienten von etwa 16 K-1 aufweist, nicht so weit beabstandet ist, dass nach einer Aushärtung der Hüllmateriallage 35 mit Delaminationen zwischen der Hüllmateriallage 35 und dem Trägersubstrat 30 gerechnet werden müsste. Vielmehr ist die auch nach Aushärtung verbleibende Flexibilität des Hüllmaterials 35 ausreichend, um die Differenz im Ausdehnungskoeffizienten ausgleichen zu können.

Durch die Fixierung der Chips 33 während des Laminiervorgangs, welche im vorliegenden Fall durch die adhäsive Beschichtung 32 erfolgt, wird verhindert, dass während der Aushärtung des Hüllmaterials 35 eine Positionsänderung der Chips 33 auf dem Trägersubstrat 30 erfolgt.

Wie Fig. 4 zeigt, werden nach dem Aushärten des Materials der Hüllmateriallage 35 von einer Oberseite 37 der Hüllmateriallage 35 her Kontaktausnehmungen 38 in der Hüllmateriallage 35 ausgebildet, die zur Ausbildung einer inneren Kontaktfläche 39 das Kontaktmaterial 31 des Trägersubstrats 30 freilegen. Vorzugsweise kann die Ausbildung der Kontaktausnehmungen 38 durch eine Beaufschlagung der Oberseite 37 der Hüllmateriallage 35 mit Laserstrahlung erfolgen.

Anschließend erfolgt, wie in Fig. 5 dargestellt, die Verfüllung der Kontaktausnehmungen 38 mit einem Kontaktmaterial 40, das beispielsweise autokatalytisch auf die Kontaktflächen 39 abgeschieden werden kann, wobei vorzugsweise vor Abscheidung des Kontaktmaterials 40 auf die Kontaktflächen 39 eine Bekeimung der Kontaktflächen 39 mit beispielsweise Zinkat oder Palladium erfolgen kann, um die Haftung zwischen dem auf die Kontaktfläche 39 abgeschiedenen Kontaktmaterial 40 und der Kontaktfläche 39 zu verbessern. Als Kontaktmaterial 40 wird vorzugsweise eine mit dem Kontaktmaterial 31 übereinstimmende, zumindest überwiegend Kupfer aufweisende Materialzusammensetzung gewählt.

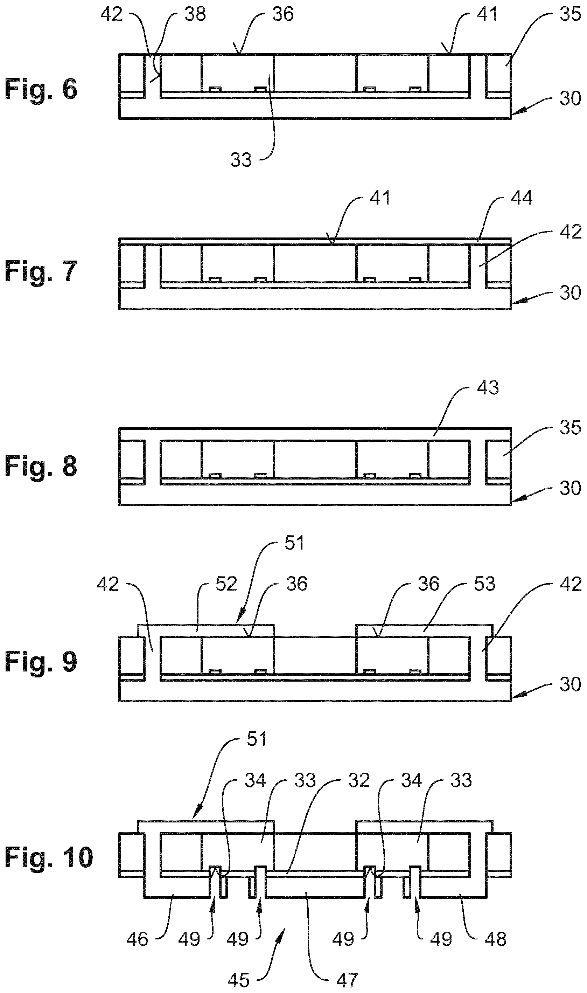

Anschließend erfolgt, wie in Fig. 6 dargestellt, eine Material abtragende Bearbeitung der Hüllmateriallage 35, mit dem Ergebnis, dass in der dadurch erzeugten Hüllmaterialoberfläche 41 sowohl die Oberflächen von durch das Kontaktmaterial 40 in den Kontaktausnehmungen 38 ausgebildeten Kontaktmaterialsäulen 42 als auch die Chiprückseiten 36 bündig in der Hüllmaterialoberfläche 41 angeordnet sind. Dabei kann gleichzeitig eine Dünnung der Chips 33, also eine Reduzierung der Höhe der Chips 33, erfolgen.

In einem nachfolgenden Verfahrensschritt erfolgt, vorzugsweise nach vorausgehender Ausbildung einer in Fig. 7 dargestellten Basismetallisierung 44 auf der Hüllmaterialoberfläche 41, die Ausbildung einer in Fig. 8 dargestellten Kontaktmateriallage 43 auf der Hüllmateriallage 35, wobei vorzugsweise als Kontaktmaterial der Kontaktmateriallage 43 Kupfer oder eine Kupfer-Legierung gewählt wird. Die Ausbildung der Zwischenmetallisierung 44 kann beispielsweise durch eine Abscheidung des Materials der Basismetallisierung 44 auf die Hüllmaterialoberfläche 41 erfolgen, beispielsweise durch Sputtern einer Titan/Kupfer-Legierung. Auf die Basismetallisierung 44 kann anschließend die Kontaktmateriallage 43 durch Abscheidung aufgebracht werden, wobei die Abscheidung wahlweise galvanisch oder auch autokatalytisch erfolgen kann.

Zur Ausbildung einer in Fig. 9 dargestellten Chiprückseiten-Kontaktleiteranordnung 51 erfolgt vorzugsweise eine lithographische Strukturierung der auf die Hüllmateriallage 35 aufgebrachten Kontaktmateriallage 43, derart, dass die Chiprückseiten-Kontaktleiteranordnung 51 im vorliegenden Fall zwei Kontaktleiter 52, 53 aufweist, welche jeweils eine Chiprückseite 36 mit einer Kontaktsäule 42 verbinden.

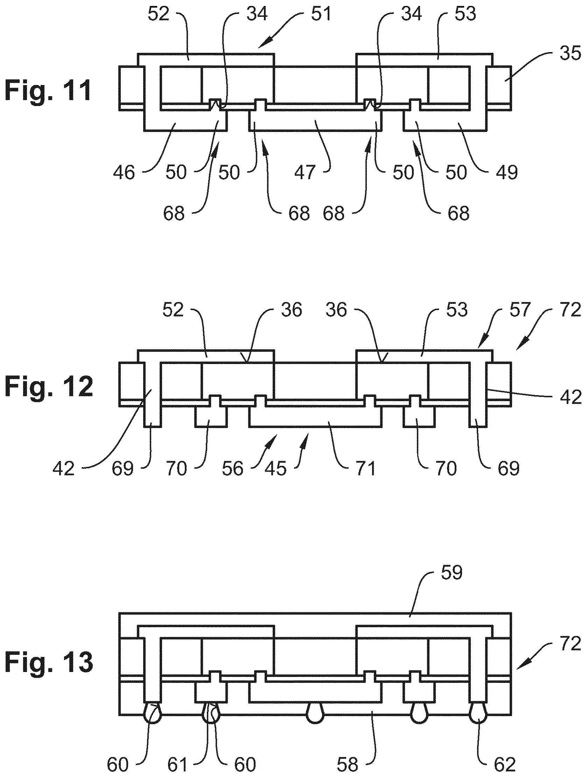

Zur Ausbildung einer durch Strukturierung des Trägersubstrats 30 erzeugten und in Fig. 12 dargestellten Kontaktleiteranordnung 45 erfolgt nunmehr, wie aus der Abfolge der Fig. 10 und 11 deutlich wird, zunächst eine Bearbeitung des Trägersubstrats 30 in einem ersten lithographischen Verfahrensschritt, so dass einerseits Kontaktleiter 46, 47, 48 und zum anderen Kontaktausnehmungen 49 im Trägersubstrat 30 ausgebildet werden. Vorzugsweise erfolgt ergänzend zum Lithographieverfahren nachfolgend der Entfernung des Kontaktmaterials 31 des Trägersubstrats 30 zur Ausbildung der Kontaktausnehmungen 49 noch eine Laserbeaufschlagung der Chipanschlussflächen 34, um diese oberflächlich zu reinigen, also insbesondere etwaige verbliebene Rückstände der adhäsiven Beschichtung 32 zu entfernen. Die Ausbildung von Verbindungskontakten 68, die die Kontaktleiter 46, 47, 48 mit den Chipanschlussflächen 34 verbinden, erfolgt dann vorzugsweise durch autokatalytische Abscheidung eines Kontaktmaterials 50, das vorzugsweise aus Kupfer oder einer Kupferlegierung besteht und das weiterhin vorzugsweise auf die zuvor mit Zinkat oder Palladium bekeimten Chipanschlussflächen 34 stromlos abgeschieden wird.

Ausgehend von den in Fig. 11 dargestellten und in dem ersten lithografischen Verfahrensschritt ausgebildeten Kontaktleitern 46, 47, 48 erfolgt die Fertigstellung der in Fig. 12 dargestellten Kontaktleiteranordnung 45 und damit die Ausbildung eines auf Basis des in Fig. 1 dargestellten Trägesubstrats 30 hergestellten Chipmoduls 72 in einem zweiten lithografischen Verfahrensschritt, in dem aus den Kontaktleitern 46 und 48 Anschlusskontakte 69, 70 und 71 gebildet werden. Dabei ermöglichen die Anschlusskontakte 69 über die Kontaktsäulen 42 und die Kontaktleiter 52 bzw. 53 eine Kontaktierung der Chiprückseiten 36 und die Anschlusskontakte 70, 71 eine Kontaktierung der Chipanschlussflächen 34.

Wie eine Zusammenschau der Fig. 12 und 13 zeigt, wird anschließend sowohl eine Anschlusskontaktseite 56 als auch eine Rückseite 57 des Chipmoduls 72 mit einer vorzugsweise aus einem Epoxydharz gebildeten Passivierung 58, 59 versehen, wobei in der Passivierung 58 der Außenkontaktseite 56 Kontaktausnehmungen 60 ausgebildet werden, die Kontaktflächen 61 freilegen, so dass auf die Kontaktflächen 61 Lotbumps 62 aufgebracht werden können, die Kontaktstellen für eine etwaige äußere Kontaktierung des Chipmoduls 72 ermöglichen.

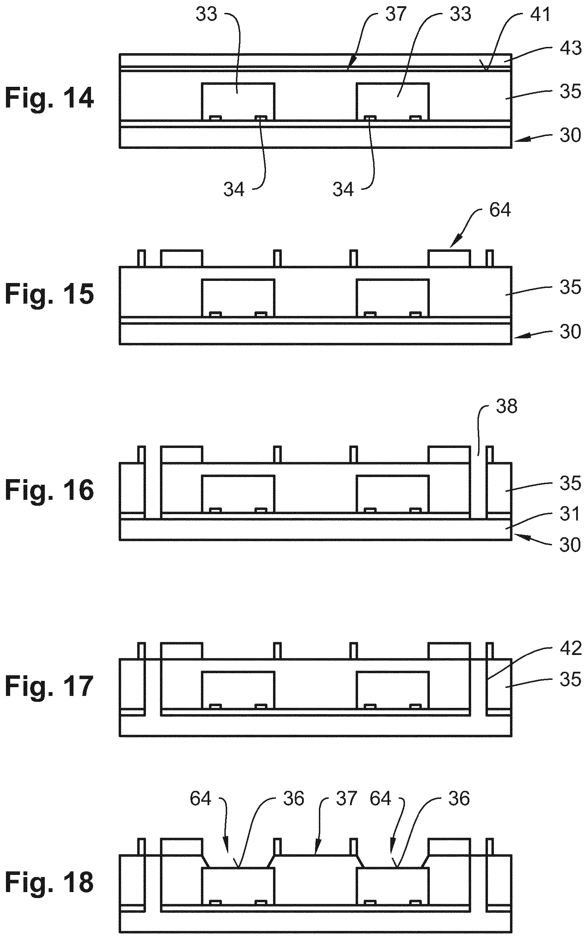

In der Abfolge der Fig. 14 bis 21 ist eine Variante des Verfahrens dargestellt, bei der ausgehend von dem in Fig. 3 dargestellten Verfahrensstand, also nachfolgend der Positionierung und Fixierung der Chips 33 mit ihren mit den Chipanschlussflächen 34 versehenen Kontaktseiten auf dem Trägersubstrat 30, die Oberseite 37 der Hüllmateriallage 35 mit der Kontaktmateriallage 43 versehen wird, ohne dass zuvor, wie in Fig. 6 dargestellt, eine Material abtragende Bearbeitung der Hüllmaterialoberfläche 41 erfolgt ist.

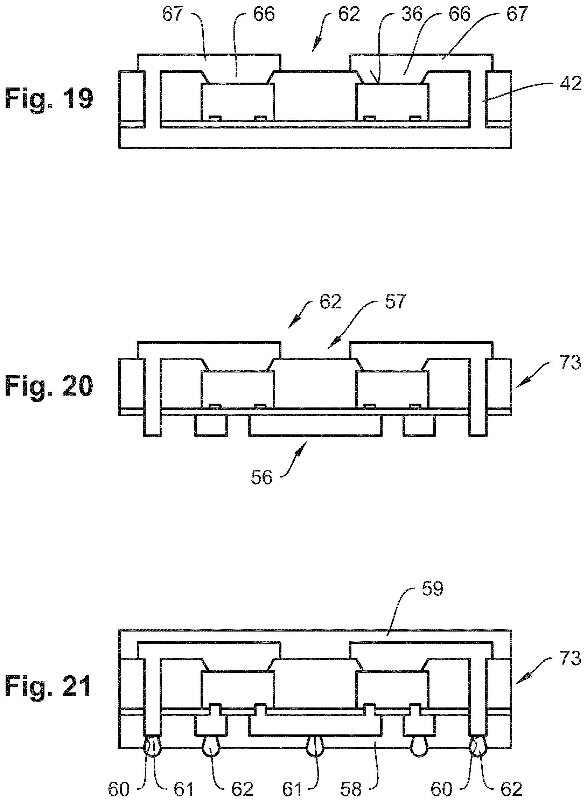

Wie in Fig. 15 dargestellt, erfolgt anschließend in einem ersten Schritt zur Ausbildung einer in Fig. 19 dargestellten Chiprückseitenkontaktleiteranordnung 62, vorzugweise durch Einsatz eines lithographischen Verfahrens, die Ausbildung einer Kontaktstruktur 63 auf der Hüllmateriallage 35 und anschließend, wie in Fig. 16 dargestellt, die Ausbildung von Kontaktausnehmungen 64 in der Hüllmateriallage 35, die im Bereich von Kontaktflächen 39 das Kontaktmaterial 31 des Trägersubstrats 30 frei legen, so dass, wie in Fig. 17 dargestellt, und wie bereits Bezug nehmend auf die Fig. 4 und 5 beschrieben, Kontaktsäulen 42 in der Hüllmateriallage 35 ausgebildet werden können.

Nach der in Fig. 18 dargestellten Freilegung der Chiprückseiten 36, beispielsweise durch Beaufschlagung der Oberseite 37 der Hüllmateriallage 35 mittels Laserstrahlung, werden auf den Chiprückseiten 36 in der Hüllmateriallage 35 gebildete Kontaktausnehmungen 64 und Kontaktoberflächen 65 der Kontaktsäulen 42 vorzugsweise durch stromlose Abscheidung von Kupfer oder einer Kupferlegierung mit einem Kontaktmaterial 66 versehen, das in Verbindung mit der zuvor durch Strukturierung der Kontaktmateriallage 43 ausgebildeten Kontaktstruktur 63 Kontaktleiter 67 ausbildet, welche jeweils eine Chiprückseite 36 mit einer Kontaktsäule 42 verbinden, wie in Fig. 19 dargestellt.

Zur Ausbildung der Kontaktleiteranordnung 45 aus dem Trägersubstrat 30 erfolgt nunmehr, wie bereits Bezug nehmend auf die Fig. 10 bis 12 beschrieben, die Strukturierung des Trägersubstrats 30, so dass das in Fig. 20 dargestellte Chipmodul 73 ausgebildet wird.

Wie eine Zusammenschau der Fig. 20 und 21 zeigt, wird anschließend sowohl die Anschlusskontaktseite 56 als auch eine Rückseite 57 des Chipmoduls 73 mit einer vorzugsweise aus einem Epoxydharz gebildeten Passivierung 58, 59 versehen, wobei in der Passivierung 58 der Außenkontaktseite 56 Kontaktausnehmungen 60 ausgebildet werden, die Kontaktflächen 61 freilegen, so dass auf die Kontaktflächen 61 Lotbumps 62 aufgebracht werden können, die Kontaktstellen für eine etwaige äußere Kontaktierung des Chipmoduls 73 ermöglichen.

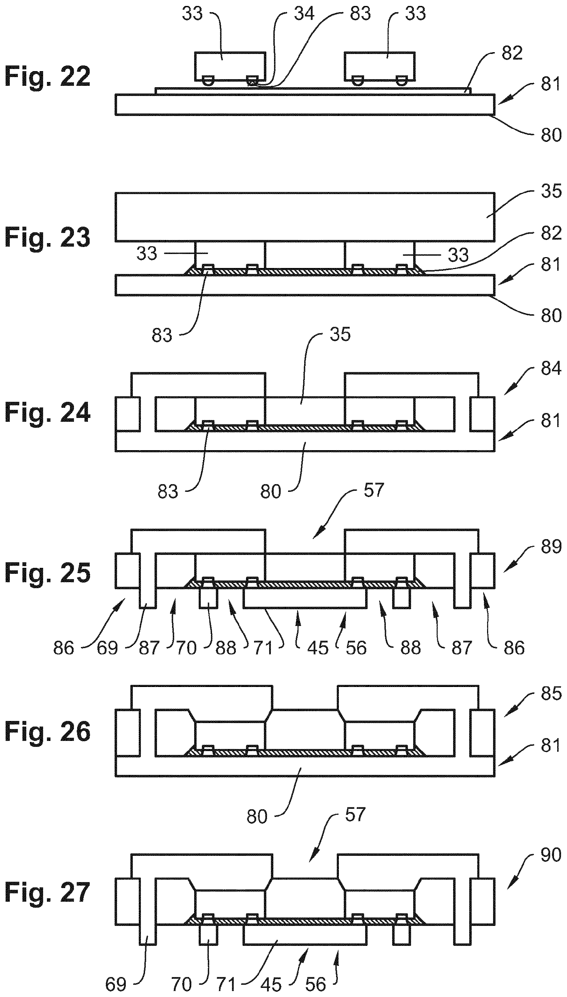

In den Fig. 22 und 23 ist eine Alternative zu der in den Fig. 10 und 11 dargestellten Kontaktierung der Chipanschlussflächen 34 mit dem Trägersubstrat 30 durch Ausbildung von Kontaktausnehmungen 49 in der Kontaktmateriallage 31 durch Strukturierung der Kontaktmateriallage 31 und nachfolgende Verfüllung der Kontaktausnehmungen 49 mit Kontaktmaterial 50 dargestellt. Hierzu erfolgt bereits vor Ausbildung der in den Fig. 25 und 27 dargestellten Kontaktleiteranordnung 45 eine Kontaktierung der Chipanschlussflächen 34 mit einer Kontaktmateriallage 80 eines Trägersubstrats 81, das mit einem elektrisch nicht leitenden Kleberauftrag 82 versehen ist.

Bei dem in den Fig. 22 und 23 dargestellten Ausführungsbeispiel sind zur Vorbereitung der Kontaktierung der Chipanschlussflächen 34 mit der Kontaktmateriallage 80 die Chipanschlussflächen 34 mit Kontakterhöhungen 83 versehen, die zur Anlage gegen die Kontaktmateriallage 80 gebracht und nachfolgend durch Aufschmelzen mit der Kontaktmateriallage 80 verbunden werden. Bei dem dargestellten Ausführungsbeispiel erfolgt mittels des Kleberauftrags 82 vor Durchführung der Verbindung eine Fixierung der Chips 33 auf dem Trägersubstrat 81.

Zum Aufschmelzen der Kontakterhöhungen 83 werden die Kontaktmateriallage 80 oder die Chips 33 von ihrer Rückseite her mit Laserstrahlung beaufschlagt.

Nach Herstellung der in Fig. 23 dargestellten Verbindung der Chips 33 mit dem Trägersubstrat 81 erfolgen die bereits unter Bezugnahme auf die Fig. 3 bis 9 betreffend die Herstellung des Chipmoduls 72 und die Fig. 14 bis 19 betreffend die Herstellung des Chipmoduls 73 erläuterten Verfahrensschritte, so dass eine in Fig. 24 bzw. Fig. 26 dargestellte Laminatstruktur 84 bzw. 85 auf Basis des Trägersubstrats 81 hergestellt wird.

Auf Basis der Laminatstruktur 84 bzw. 85, die bis dahin noch eine nicht strukturierte Kontaktmateriallage 80 des Trägersubstrats 81 aufweist, erfolgt nun eine in den Fig. 25 und 27 dargestellte Strukturierung der Kontaktmateriallage 80 zur Ausbildung der Kontaktleiteranordnung 45, derart, dass zur Definition der Anschlusskontakte 69, 70, 71 vorzugsweise durch ein fotolithografisches Verfahren oder Laserablation Kontaktausnehmungen 86, 87, 88 in der Kontaktmateriallage 80 ausgebildet werden.

Die so hergestellten Chipmodule 89, 90 können anschließend noch wie die in den Fig. 13 und 21 dargestellten Chipmodule 72, 73 sowohl auf der Anschlusskontaktseite 56 als auch ihrer Rückseite 57 mit einer vorzugsweise aus einem Epoxydharz gebildeten Passivierung 58, 59 versehen werden, wobei in der Passivierung 58 der Außenkontaktseite 56 Kontaktausnehmungen 60 ausgebildet werden, die Kontaktflächen 61 freilegen, so dass auf die Kontaktflächen 61 Lotbumps 62 aufgebracht werden können, die Kontaktstellen für eine etwaige äußere Kontaktierung der Chipmodule 89, 90 ermöglichen.

## Patentansprüche

1. Verfahren zur Herstellung eines Chipmoduls (72, 89) mit einem Trägersubstrat (30, 81) und zumindest einem auf dem Trägersubstrat angeordneten Chip (33) sowie einer Kontaktleiteranordnung (45) zur Verbindung von Chipanschlussflächen (34) mit auf einer Kontaktseite (56) des Chipmoduls angeordneten Anschlusskontakten (69, 70, 71), bei dem der Chip (33) mit seiner mit den Chipanschlussflächen (34) versehenen Frontseite auf dem Trägersubstrat (30, 81) fixiert wird,
wobei vor Ausbildung der Kontaktleiteranordnung (45) zur Ausbildung einer den Chip (33) einhäusenden Hüllmateriallage (35) ein Hüllmaterial auf das Trägersubstrat (30, 81) aufgebracht wird, die Hüllmateriallage (35) von ihrer Oberseite (37) her mit zumindest einer Kontaktausnehmung (38) versehen wird, die zur Ausbildung einer Kontaktfläche (39) auf einer Kontaktmateriallage (31) des Trägersubstrats (30) das Kontaktmaterial (40) freilegt, die Kontaktausnehmung (38) zur Ausbildung einer Kontaktsäule (42) mit Kontaktmaterial (40) verfüllt wird,
und die Hüllmateriallage (35) von ihrer Oberseite (37) her zur Freilegung einer Chiprückseite (36) Material abtragend bearbeitet wird, derart, dass die Chiprückseite und die Kontaktsäule (42) bündig in einer durch die Bearbeitung ausgebildeten Hüllmaterialoberfläche (41) angeordnet sind,
wobei nachfolgend auf die Hüllmaterialoberfläche (41) und die Chiprückseite (36) und die Kontaktsäule (42) eine Basismetallisierung (44) aufgebracht wird, auf die eine Kontaktmaterialschicht (43) aufgebracht wird,
**dadurch gekennzeichnet,**
**dass** nachfolgend zur Ausbildung einer Chiprückseitenkontaktleiteranordnung (51) die Kontaktmaterialschicht (43) strukturiert wird, derart, dass die Chiprückseite (36) über die Kontaktsäule (42) mit der auf der Frontseite des Chipmoduls (33) angeordneten Kontaktleiteranordnung (45) elektrisch leitend verbunden ist,
und **dass** nachfolgend der Fixierung des Chips (33) mit seiner mit den Chipanschlussflächen (34) versehenen Frontseite auf dem Trägersubstrat (30, 81) die Ausbildung der Kontaktleiteranordnung (45) durch eine Strukturierung der Kontaktmateriallage (31, 80) des Trägersubstrats erfolgt, wobei durch die Strukturierung der Kontaktmateriallage (31) des Trägersubstrats (30) in Überdeckung mit den Chipanschlussflächen (34) Kontaktausnehmungen (49) ausgebildet werden, die zur Kontaktierung der Chipanschlussflächen mit der Kontaktleiteranordnung (45) mit Kontaktmaterial (50) verfüllt werden.

2. Verfahren nach Anspruch 1, wobei die Fixierung des Chips (33) auf dem Trägersubstrat (30) mittels einer adhäsiven Beschichtung (32) der Kontaktmateriallage (31) des Trägersubstrats erfolgt.

3. Verfahren nach Anspruch 2, wobei das Trägersubstrat aus einer mit der adhäsiven Beschichtung (32) versehenen Kontaktmaterialfolie gebildet ist.

4. Verfahren nach einem der Ansprüche 1 bis 3, wobei als Kontaktmaterial (40, 50) ein Lotmaterial verwendet wird.

5. Verfahren nach Anspruch 4, wobei das Kontaktmaterial (40, 50) durch ein Abscheideverfahren in die Kontaktausnehmungen (38, 49) eingebracht wird.

6. Verfahren nach einem der vorangehenden Ansprüche, wobei vor Ausbildung der Kontaktleiteranordnung (45) eine Kontaktierung der Chipanschlussflächen (34) mit der Kontaktmateriallage (80) erfolgt.

7. Verfahren nach Anspruch 6, wobei zur Kontaktierung der Chipanschlussflächen (34) mit der Kontaktmateriallage (80) die mit Kontakterhöhungen (83) versehenen Chipanschlussflächen zur Anlage gegen die Kontaktmateriallage (80) gebracht werden, und nachfolgend die Verbindung der Chipanschlussflächen mit der Kontaktmateriallage durch Aufschmelzen der Kontakterhöhungen erfolgt.

8. Verfahren nach Anspruch 7, wobei das Aufschmelzen der Kontakterhöhungen (83) mittels einer Laserbeaufschlagung des Chips (33) oder der Kontaktmateriallage (80) erfolgt.

9. Verfahren nach einem der vorangehenden Ansprüche, wobei das Hüllmaterial als Hüllmateriallage (35) auf den Chip (33) aufgelegt wird, derart, dass der Chip sandwichartig zwischen der Hüllmateriallage und dem Trägersubstrat angeordnet ist, und die Hüllmateriallage nachfolgend in einem Laminiervorgang zur Ausbildung einer das Trägersubstrat (30, 81) umfassenden Laminatstruktur mit dem Trägersubstrat verbunden wird.

10. Verfahren nach einem der vorangehenden Ansprüche, wobei die Kontaktmaterialschicht (43) durch Abscheidung aufgebracht wird.

## Claims

1. A method for producing a chip module (72, 89) having a carrier substrate (30, 81) and at least one chip (33) arranged on the carrier substrate, as well as a contact conductor arrangement (45) for connecting chip terminal faces (34) with terminal contacts (69, 70, 71) arranged on a contact side (56) of the chip module, in which method the chip (33) is secured on the carrier substrate (30, 81) with its front side provided with the chip terminal faces (34), wherein
before the forming of the contact conductor arrangement (45) for forming a cladding material layer (35) encasing the chip (33), a cladding material is applied onto the carrier substrate (30, 81), the cladding material layer (35) is provided with at least one contact recess (38), starting from its upper side (37), said contact recess exposing the contact material (40) for forming a contact surface (39) on a contact material layer (31) of the carrier substrate (30),
the contact recess (38) is backfilled with contact material (40) for forming a contact column (42),
and the cladding material layer (35) is treated by material abrasion, starting from its upper side (37), for exposing a rear side (36) of the chip, in such a way that the rear side of the chip and the contact column (42) are aligned flush in a cladding material surface (41) produced by said treatment,
subsequently a base metallization (44) is applied to the cladding material surface (41) and to the rear side (36) of the chip and to the contact column (42), a contact material layer (43) being applied to said base metallization (44),
**characterized in that**
subsequently the contact material layer (43) is structured for forming a contact conductor arrangement (51) on the rear side of the chip, in such a way that the rear side (36) of the chip is connected with the contact conductor arrangement (45) located on the front side of the chip module (33) in an electrically conductive manner via the contact column (42), and **in that**, after the securing of the chip (33) with its front side provided with the chip terminal faces (34) on the carrier substrate (30, 81), the forming of the contact conductor arrangement (45) is effected by means of structuring the contact material layer (31, 80) of the carrier substrate, contact recesses (49) being formed by means of the structuring of the contact material layer (31) of the carrier substrate (30) in superposition with the chip terminal faces (34), said contact recesses being backfilled with contact material (50) for contacting the chip terminal faces with the contact conductor arrangement (45).

2. The method according to claim 1,
wherein the securing of the chip (33) on the carrier substrate (30) is effected by means of an adhesive coating (32) of the contact material layer (31) of the carrier substrate.

3. The method according to claim 2,
wherein the carrier substrate is formed from a contact material foil provided with the adhesive coating (32).

4. The method according to any one of claims 1 to 3,
wherein a solder material is used as contact material (40, 50).

5. The method according to claim 4,
wherein the contact material (40, 50) is introduced into the contact recesses (38, 49) by means of a deposition process.

6. The method according to any one of the preceding claims,
wherein before the forming of the contact conductor arrangement (45) a contacting of the chip terminal faces (34) with the contact material layer (80) is effected.

7. The method according to claim 6,
wherein for contacting the chip terminal faces (34) with the contact material layer (80), the chip terminal faces provided with contact elevations (83) are brought into abutment with the contact material layer (80), and subsequently the connecting of the chip terminal faces with the contact material layer is effected by fusing of the contact elevations.

8. The method according to claim 7,
wherein the fusing of the contact elevations (83) is effected by means of an application of laser radiation to the chip (33) or to the contact material layer (80).

9. The method according to any one of the preceding claims,
wherein the cladding material is placed on the chip (33) as a cladding material layer (35), in such a way that the chip is sandwiched between the cladding material layer and the carrier substrate, and the cladding material layer is subsequently connected to the carrier substrate in a lamination process for forming a laminate structure comprising the carrier substrate (30, 81).

10. The method according to any one of the preceding claims, wherein the contact material layer (43) is applied by deposition.

## Revendications

1. Procédé de fabrication d'un module de puce (72, 89) ayant un substrat porteur (30, 81) et au moins une puce (33) disposée sur le substrat porteur, ainsi qu'un ensemble (45) de conducteurs de contact pour relier des faces (34) de raccordement de puce à des contacts (69, 70, 71) de raccordement disposés sur un côté de contact (56) du module de puce, dans lequel procédé la puce (33) est fixée sur le substrat porteur (30, 81) avec sa face avant pourvue des faces (34) de raccordement de puce, dans lequel avant la formation de l'ensemble (45) de conducteurs de contact pour former une couche (35) de matériau d'enveloppe recouvrant la puce (33), un matériau d'enveloppe est appliqué sur le substrat porteur (30, 81),
la couche (35) de matériau d'enveloppe est pourvue d'au moins un évidement de contact (38), partant de son côté supérieur (37), ledit évidement de contact exposant le matériau de contact (40) pour former une face de contact (39) sur une couche (31) de matériau de contact du substrat porteur (30),
l'évidement de contact (38) est rempli de matériau de contact (40) pour former une colonne de contact (42),
et la couche (35) de matériau d'enveloppe est traitée par abrasion de matériau, à partir de son côté supérieur (37), pour exposer une face arrière de la puce (36), de telle sorte que la face arrière de la puce et la colonne de contact (42) sont alignées à fleur dans une surface (41) de matériau d'enveloppe produite par ledit traitement, ensuite, une métallisation de base (44) est appliquée sur la surface (41) de matériau d'enveloppe, sur la face arrière de la puce (36) et sur la colonne de contact (42), une couche (43) de matériau de contact étant appliquée sur ladite métallisation de base (44),
**caractérisé en ce**
**qu'**ensuite la couche (43) de matériau de contact est structurée pour former un ensemble (51) de conducteurs de contact sur la face arrière de la puce, de telle sorte que la face arrière de la puce (36) est reliée à l'ensemble (45) de conducteurs de contact situé sur la face frontale du module de puce (33) de manière électriquement conductrice par l'intermédiaire de la colonne de contact (42), et en ce que, après la fixation de la puce (33) avec sa face arrière pourvue des faces (34) de raccordement de puce sur le substrat porteur (30, 81), la formation de l'ensemble (45) de conducteurs de contact est effectuée au moyen d'une structuration de la couche (31, 80) de matériau de contact du substrat porteur, des évidements de contact (49) étant formés au moyen de la structuration de la couche (31) de matériau de contact du substrat porteur (30) en superposition avec les faces (34) de raccordement de puce, lesdits évidements de contact étant remplis de matériau de contact (50) pour mettre en contact les faces de raccordement de puce avec l'ensemble (45) de conducteurs de contact.

2. Procédé selon la revendication 1,
dans lequel la fixation de la puce (33) sur le substrat porteur (30) est effectuée au moyen d'un revêtement adhésif (32) de la couche (31) de matériau de contact du substrat porteur.

3. Procédé selon la revendication 2,
dans lequel le substrat porteur est fait en une feuille de matériau de contact pourvue du revêtement adhésif (32).

4. Procédé selon l'une quelconque des revendications 1 à 3,
dans lequel un matériau de soudure est utilisé comme matériau de contact (40, 50).

5. Procédé selon la revendication 4,
dans lequel le matériau de contact (40, 50) est introduit dans les évidements de contact (38, 49) au moyen d'un procédé de dépôt.

6. Procédé selon l'une quelconque des revendications précédentes,
dans lequel, avant la formation de l'ensemble (45) de conducteurs de contact, un contact des faces (34) de raccordement de puce avec la couche (80) de matériau de contact est effectué.

7. Procédé selon la revendication 6,
dans lequel, pour mettre en contact les faces (34) de raccordement de puce avec la couche (80) de matériau de contact, les faces de raccordement de puce pourvues de saillies de contact (83) sont amenées en butée avec la couche (80) de matériau de contact, et ensuite la liaison des faces de raccordement de puce avec la couche de matériau de contact est réalisée par fusion des saillies de contact.

8. Procédé selon la revendication 7,
dans lequel la fusion des saillies de contact (83) est effectuée au moyen d'une application de rayonnement laser sur la puce (33) ou sur la couche (80) de matériau de contact.

9. Procédé selon l'une quelconque des revendications précédentes,
dans lequel le matériau d'enveloppe est placé sur la puce (33) sous forme de couche (35) de matériau d'enveloppe, de telle sorte que la puce est prise en sandwich entre la couche de matériau d'enveloppe et le substrat porteur, et la couche de matériau d'enveloppe est ensuite reliée au substrat porteur dans un procédé de laminage, pour former une structure laminée comprenant le substrat porteur (30, 81).

10. Procédé selon l'une quelconque des revendications précédentes,
dans lequel la couche (43) de matériau de contact est appliquée par dépôt.
